**Europäisches Patentamt**

**European Patent Office**

**Office européen des brevets**

(19)

(11) Veröffentlichungsnummer: **0 135 686**
**B1**

(12) ## EUROPÄISCHE PATENTSCHRIFT

(45) Veröffentlichungstag der Patentschrift:
**11.05.88**

(51) Int. Cl.⁴: **H 03 M 1/18**

(21) Anmeldenummer: **84107714.2**

(22) Anmeldetag: **03.07.84**

(54) Integrierte Halbleiterschaltung mit einem Mikroprozessor und einem Analog-Digitalwandler.

(30) Priorität: **02.08.83 DE 3327879**

(73) Patentinhaber: **Siemens Aktiengesellschaft Berlin und München, Wittelsbacherplatz 2, D-8000 München 2 (DE)**

(43) Veröffentlichungstag der Anmeldung:
**03.04.85 Patentblatt 85/14**

(72) Erfinder: **Kessler, Heinrich, Dipl.-Phys., Washingtonstrasse 19, D-8000 München 19 (DE)**

(45) Bekanntmachung des Hinweises auf die Patenterteilung:
**11.05.88 Patentblatt 88/19**

(84) Benannte Vertragsstaaten:
**AT DE FR GB IT**

(56) Entgegenhaltungen:
**SIEMENS FORSCHUNGS- UND ENTWICKLUNGSBERICHTE, Band 8, Nr. 5, 1979, Seiten 261-263, Berlin, DE; H. KESSLER et al.: "Ein 8-Bit-Analog-Digital-Wandler in MOS-Silizium-Gate-Technologie nach dem Ladungsverteilungsverfahren"
NACHRICHTENTECHNIK-ELEKTRONIK, Band 33, Nr. 1, 1983, Seiten 12-14, Berlin, DD; V.BROVKOV: "12-bit-Analog-Digital-Umsetzer mit stufen-paralleler Verarbeitung"
IEEE INTERNATIONAL SOLID-STATE CIRCUITS CONFERENCE, 13. Februar 1980, Seiten 16-17, IEEE, New York, USA; L.A. BIENSTMAN et al.: "An 8-channel 8b muP compatible NMOS converter with programmable ranges"**

# Beschreibung

Die vorliegende Erfindung befasst sich mit einer integrierten Halbleiterschaltung für Analog-Digital-Wandlungszwecke.

Als Stand der Technik kann hier die Literaturstelle «Siemens Forschungs- und Entwicklungsberichte, Bd. 8 (1979) Nr. 5, S. 261–263» genannt werden. Dort ist darauf hingewiesen, dass der verstärkte Einsatz digitaler Steuerelektronik in Form von Mikroprozessoren und Mikrocomputern in entsprechend grösserem Ausmass Analog-Digitalwandler und Digital-Analogwandler als Schnittstellen zwischen der analogen Umwelt und dem Rechner notwendig macht. Von besonderem Interesse sind dabei Wandlerbausteine, die in der gleichen Technologie wie der Mikroprozessor hergestellt werden und somit auf dem Rechnerchip mitintegriert werden können. Dabei empfiehlt es sich im Interesse einer hohen Wandlergeschwindigkeit Wandler anzuwenden, die nach dem Prinzip der schrittweisen Annäherung (= sukzessive Approximation) arbeiten. Ausserdem ist es vorteilhaft, wenn das bei nach dem Prinzip der schrittweisen Näherung arbeitenden Analog-Digitalwandlern notwendige Präzisionsnetzwerk durch ein aus MOS-Kondensatoren bestehendes Kapazitätsnetzwerk (anstelle des sonst üblichen Widerstandsnetzwerks, z.B. R/2R-Netzwerks) realisiert ist. Diesbezügliche Einzelheiten sind in der genannten Literaturquelle angegeben.

Zur Steuerung von Vorgängen, die analoge Messgrössen bringen, wendet man somit eine monolithische Kombination eines Einchip-Rechners mit einem A/D-Wandler an. Dabei ist der integrierte A/D-Wandler meist für mehrere analoge Messstellen zuständig, die – abhängig von den jeweils verwendeten Informationsgebern an den Messstellen – verschiedene, nicht deckungsgleiche, analoge Spannungsbereiche besitzen. Das bedeutet aber, dass die volle Auflösung des Wandlers (häufig 8 Bit) für eine Messstelle nicht voll ausgenutzt werden kann.

Man könnte nun zur Lösung des soeben angedeuteten Problems den auf dem Rechnerchip mitintegrierten Analog-Digitalwandler mit einer entsprechend höheren Auflösung, z.B. mit einer Auflösung von 10 Bit, versehen, als sie für die einzelnen Messstellen an sich nötig ist. Durch das Rechnerprogramm wird dann die mit beispielsweise 10 Bit Breite gewandelte Messgrösse durch Normierungsalgorithmen auf die gewünschte Grösse mit geringerer Bitbreite gebracht.

Eine andere Anordnung für einen Analog-Digital-Wandler ist in «Nachrichtentechnik Elektronik», Band 33, Nr. 1, 1983, Seiten 12–14, insbesondere in Bild 2 gezeigt: Einem Analog-Digital-Umsetzer ADU ist (offensichtlich in diskreter Schaltungstechnik) eine separate Steuerlogik nachgeschaltet, die aus dem aus dem Analog-Digital-Umsetzer austretenden m Bit breiten Digitalsignal einerseits ein solches von n Bit Datenbreite erzeugt und andererseits zwei Referenzpotentiale $U_{REF1}$, $U_{REF2}$ über je einen Digital-Analog-Umsetzer DAU1, DAU2 ableitet. Die Referenzpotentiale dienen dann dem Analog-Digital-Umsetzer als Fusspunkt- bzw. Referenzpotential.

Aufgabe der vorliegenden Erfindung ist es, eine Halbleiterschaltung zu schaffen, an die verschiedene Analogmesswerte anlegbar sind und die das oben gezeigte Problem optimal löst.

Diese Aufgabe wird gelöst durch die Merkmale des Patentanspruchs 1.

Vorteilhafte Aus- und Weiterbildungen sind in Unteransprüchen gekennzeichnet.

Die Erfindung weist folgende Vorteile auf:

1. Es ist kein Zusatzaufwand für die Normierung des Ergebnisses erforderlich.

2. Es reicht ein Analog-Digitalwandler mit einer Auflösung, die nicht grösser sein muss als es die für das Messergebnis erforderliche Genauigkeit verlangt. Erfahrungsgemäss steigt nämlich der Aufwand für das Referenznetzwerk eines A/D-Wandlers exponentiell mit der durch den Wandler zu erreichenden Auflösung.

3. Bei einem Analog-Digitalwandler, der nach dem Prinzip der kapazitiven Ladungsverteilung arbeitet, kann ohne grossen Zusatzaufwand eine Erweiterung durch den bzw. die mitvorgesehenen D/A-Wandler bei der erfindungsgemässen Schaltung erreicht werden.

Zu der gemäss der Erfindung vorgesehenen D/A-Wandlung kann sowohl das kapazitive Referenznetzwerk des A/D-Wandlers als auch dessen Differenzverstärker verwendet werden. Für die D/A-Wandlung ist ausserdem für jedes der die Referenzspannung $U_{ref}$ bildenden Potentiale GND und REF je ein Register für die Speicherung des zugehörigen digitalen Wertes des Potentials, je ein (interner) Kondensator zur dynamischen Speicherung des Analogwertes sowie ein – beispielsweise als Sourcefolger ausgeführter – niederohmiger Ausgangsverstärker bei einer bevorzugten Ausgestaltung der Erfindung vorgesehen.

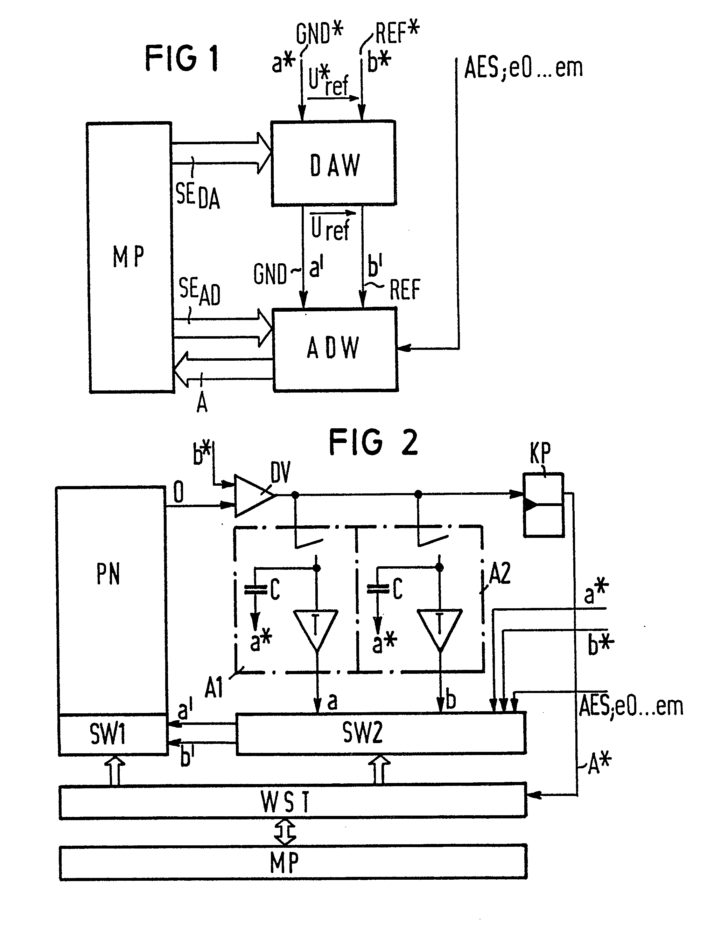

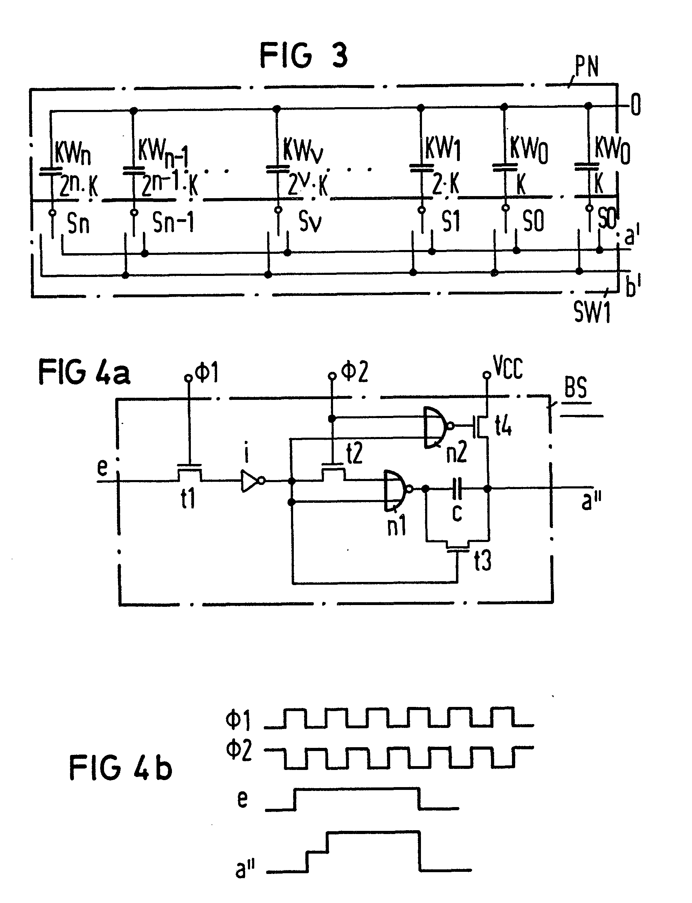

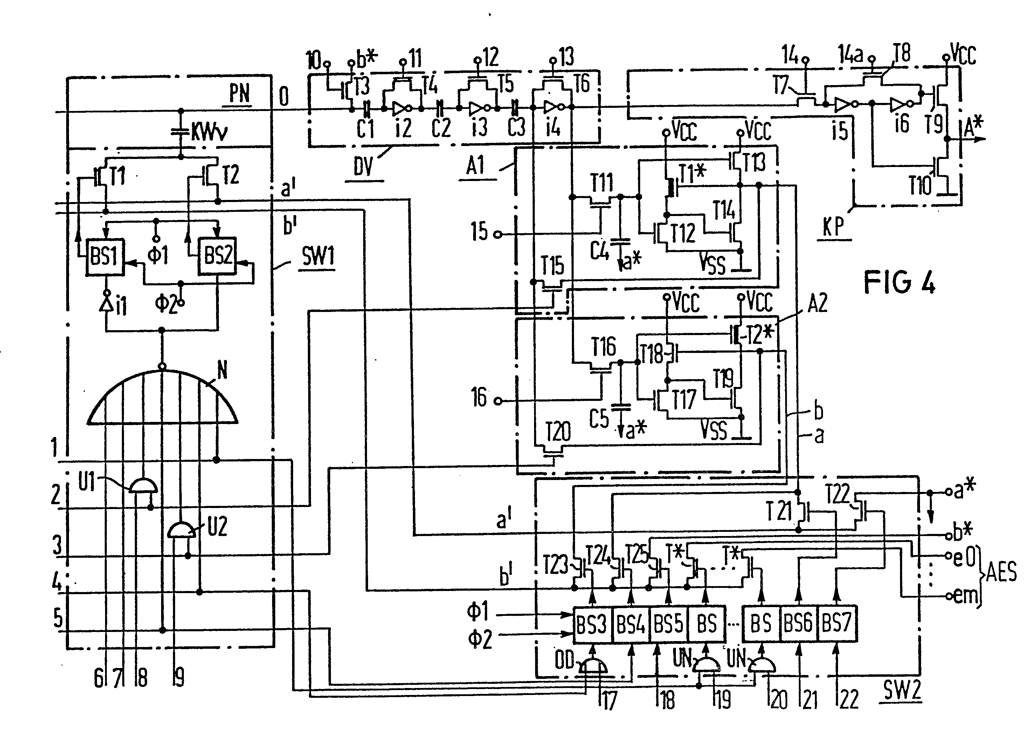

Die Erfindung wird nun anhand der Figuren 1–4 näher beschrieben. Dabei stellt Figur 1 ein allgemeines Blockschaltbild für eine der Erfindung entsprechende integrierte Halbleiterschaltung dar, während Figur 2 ein auf die soeben angegebene vorteilhafte Ausbildung bezogenes Blockschaltbild gezeigt ist. Figur 3 und 4 stellen schliesslich zusammen ein detailliertes Schaltbild für eine besonders vorteilhafte Ausgestaltung der Erfindung gemäss Figur 2 dar.

Das in Figur 1 dargestellte Blockschaltbild entspricht der oben gegebenen Definition der Erfindung. Es enthält einen insbesondere zu einem Mikrocomputer ergänzten Mikroprozessor MP und einen mit ihm monolithisch zusammengefassten Analog-Digitalwandler ADW. Letzterer ist an seinem Signaleingang von den zu verarbeitenden analogen Eingangssignalen AES beaufschlagt, die dann in Form von digitalen Daten an den Dateneingang des Mikroprozessors MP weitergegeben werden.

Gemäss der Erfindung ist nun ein Schaltungsteil DAW mitintegriert, der seinerseits durch den Mikroprozessor MP gesteuert wird und die die Referenzspannung $U_{ref}$ des A/D-Wandlers bildenden Potentiale GND und REF nach Vorgabe des Mikroprozessors MP erzeugt.

Der extern mit einer von einer Spannungsquelle zur Verfügung gestellten festen Referenzspannung $U^*_{ref}$ beaufschlagte Schaltungsteil DAW hat zu diesem Zweck zwei extern beaufschlagte Eingänge, wobei der Eingang a* das externe Fusspunktspotential GND* und der Eingang b* das zusammen mit dem externen Fusspunktspotential GND* die externe Referenzspannung $U^*_{ref}$ bildende externe Referenzpotential REF* erhält. Diesen beiden Eingängen des Schaltungsteils DAW entsprechen dessen beide zum Analog-Digitalwandler ADW führende interne Ausgänge a' und b', wobei a' das interne Fusspunktspotential GND und b' das interne Referenzpotential REF liefert. Der Schaltungsteil DAW ist nun so ausgestaltet, dass er aufgrund der vom Mikroprozessor MP auf ihn ausgeübten Steuerung sowohl das interne Fusspunktspotential GND als auch das interne Referenzpotential REF so einstellt, dass beide Potentiale die für den jeweiligen Fall vom Analog-Digitalwandler ADW benötigte Referenzspannung $U_{ref}$ gemeinsam liefern. Es sind also GND als auch REF für sich über den Mikroprozessor MP in unabhängiger Weise programmierbar.

Die analogen externen Signale AES werden von der vom Mikroprozessor MP aufgrund dieser Signale gesteuerten Anlage (nicht dargestellt) geliefert. Der Schaltungsteil ADW ist so ausgestaltet, dass er aufgrund der vom Mikroprozessor MP auf ihn ausgeübten Steuerung das von jenem gerade benötigte einzelne Analogsignal auswählt, es bezüglich der vom Schaltungsteil DAW gelieferten Referenzpotentiale in den entsprechenden Digitalwert umwandelt und es in einem Ergebnisregister für das Auslesen durch den Mikroprozessor MP bereitstellt.

Wie bereits oben angedeutet, ist es vorteilhaft, wenn der Schaltungsteil DAW zwei Digital-Analogwandler enthält, wobei der eine für die Einstellung des internen Fusspunktspotentials GND und der andere für die Einstellung des internen Referenzpotentials REF unter Kontrolle durch den Mikroprozessor MP zuständig ist. Eine entsprechende Ausgestaltung des Schaltungsteils DAW ist in Figur 2 dargestellt. Ausserdem enthält Figur 2 die genauere Ausgestaltung des Schaltungsteils ADW. Letzterer besteht aus dem Präzisionsnetzwerk PN, dem Differenzverstärker DV, dem Komparator-Flip-Flop KP, dem Schaltwerk SW1, einen Teil des Schaltwerks SW2 und einem Teil der Wandlersteuerung WST.

Der Schaltungsteil DAW besteht aus zwei einander im wesentlichen entsprechenden Schaltungsteilen A1 und A2 sowie den restlichen Teilen des Schaltwerks SW2 und der Wandlersteuerung WST. Zusammen mit SW2, SW1, PN, DV werden A1 und A2 von der Wandlersteuerung dergestalt gesteuert, dass sie je die Funktion eines Digital-Analogwandlers ausüben, mit der Aufgabe, je eines der beiden die interne Referenzspannung $U_{ref}$ definierenden Potentiale (also das Fusspunktspotential GND und das Referenzpotential REF) zu liefern bzw. für die Analog-Digitalwandlung zur Verfügung zu stellen. Dabei ist im gezeichneten Beispielsfall der Schaltungsteil A1 für das Fusspunktspotential GND und der Schaltungsteil A2 für das Referenzpotential REF zuständig. Beide Schaltungsteile enthalten je einen durch einen Kondensator C angedeuteten Analogspeicher und je einen Treiber T, dessen Ausgang a bzw. b das auf dem Kondensator C gespeicherte Analogpotential an die Eingänge a bzw. b des Schaltwerks SW2 liefert.

Das Schaltwerk SW2 hat ausser den beiden gerade erwähnten Eingängen a und b noch zusätzlich die Eingänge a* und b* sowie die Eingänge AES. An a* und b* wird die externe Referenzspannung $U^*_{ref}$ und an AES werden die zu messenden Analogpotentiale zugeführt. Die Aufgabe von SW2 ist, gesteuert von der Wandlersteuerung WST die erforderlichen Eingangspotentiale über die beiden Ausgänge a' und b' an das Schaltwerk SW1 weiterzuleiten. Im Schaltwerk SW1 werden – wiederum gesteuert durch die Wandlersteuerung WST – die den einzelnen Digitalbits entsprechenden Teile des Präzisionsnetzwerks mit den Eingangspotentialen a' oder b' beaufschlagt. Dadurch erscheint am Ausgang 0 des Präzisionsnetzwerks PN ein durch die Wandlersteuerung definiertes Analogsignal, dessen Differenz zu dem durch die Leitung b* definierten Referenzpotential REF* im Differenzverstärker DV verstärkt wird.

Soll eines der beiden internen Referenzpotentiale GND bzw. REF eingestellt werden, so schaltet die Wandlersteuerung vom Ausgang des Differenzverstärkers DV über A1 bzw. A2, SW2, SW1 und PN eine geschlossene Rückkoppelschleife, wodurch das Ausgangspotential a bzw. b der Schaltungsteile A1 bzw. A2 solange verändert wird, bis die Eingangsspannung am Differenzverstärker, also die Differenz der Potentiale an b* und 0, abgeglichen ist.

Der Ausgang des Differenzverstärkers DV ist ausser mit den bereits erwähnten Eingängen der Schaltungsteile A1 und A2 noch mit dem Eingang des Komperator-Flip-Flops KP verbunden. Dieses Komperator-Flip-Flop wandelt die analoge Eingangsspannung des Differenzverstärkers in ein Digitalbit um. Der Ausgang von KP liegt auf dem Pegel logisch «1», solange für die Potentiale an b* und 0 die Beziehung b*–0>«Null» gilt, und auf dem Pegel logisch «0», solange b*–0<«Null» ist. Der Ausgang des Komparator-Flip-Flops KP ist mit einem Eingang der Wandlersteuerung WST verbunden, so dass diese bei der Analog-Digitalwandlung nach dem Verfahren der sukzessiven Approximation die Wertigkeit des gerade behandelten Bits feststellen kann.

Die Wandlersteuerung WST hat zwei Aufgaben. Einerseits dient sie als einzige Schnittstelle zwischen dem Mikroprozessor MP und dem Wandler und hat andererseits als Ablaufsteuerung alle für den Ablauf der einzelnen Phasen der Digital-Analogwandlung und der Analog-Digitalwandlung benötigten Steuersignale bereitzustellen. Als Mikroprozessorschnittstelle enthält WST Register für

a) den Wert des internen Fusspunktspotentials (GDDT – Grounddata),

b) den Wert des internen Referenzpotentials (RFDT – Referencedata),

c) den Wert des Ergebnisses der A/D-Wandlung (RSDT – Resultdata),

d) die Auswahl der zu wandelnden Eingangsspannung (CAN – Convert analog Input).

Als Ablaufsteuerung leitet WST die benötigten Steuersignale aus dem Taktsystem des Mikroprozessors MP ab. Beide Aufgaben lassen sich in konventioneller Digitaltechnik lösen, weshalb auf die Realisierung der Wandlersteuerung WST im folgenden nicht näher eingegangen wird.

Der Mikroprozessor leitet mit einem Startsignal den Ablauf der Steuerung ein. Daraufhin erzeugt die Wandlersteuerung nacheinander alle Steuersignale zum erforderlichen Zeitpunkt und mit der notwendigen Dauer, wie sie zur erfindungsgemässen Durchführung der Wandlung benötigt werden. Die Steuerung kann mittels einer PLA (programmable logical array) aufgebaut werden. Eine Anleitung dazu ist beispielsweise in der Veröffentlichung der Fa. Monolithic Memories, PAL Handbook, third Edition, S. 8–8 bis 8–13 veröffentlicht.

Wie man eine den gebrachten Angaben entsprechende Schaltung gemäss der Erfindung in vorteilhafter Weise aufbauen kann, wird nun anhand der Figuren 3 und 4 gezeigt.

Wie aus Figur 3 ersichtlich, ist das Präzisionsnetzwerk PN bevorzugt als Kapazitätsnetzwerk ausgestaltet. Dies bedeutet, dass jede Stufe des Präzisionsnetzwerkes PN je einen gewichteten Kondensator $KW_v$ enthält, der mit seinem einen Anschluss am Ausgang 0 des Kapazitätsnetzwerks PN liegt und mit seinem anderen Anschluss mittels eines Umschalters $S_v$ alternativ an zwei Eingänge a', b' des Schaltwerks SW1 anlegbar ist. Die Wichtung erfolgt in üblicher Weise so, dass der für die höchste Bitwertigkeit n zuständigen Vergleichsstufe zugeteilte Kondensator $KW_n$ des Kapazitätsnetzwerks PN den Kapazitätswert $k \cdot 2^n$ erhält, wobei K den Grundwert der Kapazitätswichtung bedeutet. Die der $v$-ten Bitwertigkeit zugeteilte $v$-te Vergleichsstufe ($v = n, n–1, n–2, \ldots 2, 1, 0$) hat einen Kondensator mit dem Kapazitätswert $K \cdot 2^v$. Für die für die niedrigsten Bitwertigkeit zugeteilte Vergleichsstufe, die aus bekannten Gründen doppelt vorgesehen ist, folgt somit, dass der ihr zugeteilte Kondensator $KW_0$ aus dem Präzisionsnetzwerk PN den Kapazitätswert $KW_0 = K$ hat.

Die Figur 4 stellt die Ausgestaltung der einzelnen Vergleichsstufen im Analog-Digitalwandler sowie die Ausgestaltung der übrigen in Figur 2 dargestellten Schaltungsteile mit Ausnahme der in üblicher Weise ausgestalteten Teile Wandlersteuerung WST und Mikroprozessor MP dar. Dabei ist ein Schaltungsteil in Figur 4 aus Platzgründen lediglich als Block dargestellt, dessen bevorzugte Ausgestaltung in Figur 4a gezeigt ist. Figur 4b bringt das für die Taktsteuerung dieses Teils anzuwendende Zeitdiagramm.

Jeder der im Kapazitätsnetzwerk PN vorgesehenen Kondensatoren $KW_v$ ist, wie bereits wiederholt bemerkt, mit seinem einen Anschluss an den Ausgang 0 des Netzwerks PN gelegt, während sein anderer Anschluss mit einem Umschalter $S_v$ verbunden ist. In Figur 4 ist nun eine in MOS-Technik ausgeführte vorteilhafte Ausgestaltung dieses Umschalters $S_v$ gezeigt, wobei bezüglich der Schaltungsteile BS1 und BS2 auf die Figur 4a zu verweisen ist.

Der mit dem Kondensator $KW_v$ der einzelnen Vergleichsstufe des Präzisionsnetzwerks PN jeweils in Verbindung stehende Ausgang des Umschalters $S_v$ ist durch den Drain eines ersten MOS-Feldeffekttransistors T1 und den Drain eines zweiten MOS-Feldeffekttransistors T2 gegeben, der unmitelbar an den Kondensator $KW_v$ angeschlossen ist. Beide Transistoren T1 und T2 sind selbstsperrend und einander gleich. Bevorzugt sind sie – ebenso wie die übrigen in der Schaltung vorgesehenen Transistoren – durch je einen n-Kanaltransistor gegeben. Die Source des ersten Transistors T1 liegt am Potential b' und die Source des zweiten Transistors T2 am Potential a'. Das Gate des ersten Transistors T1 wird durch den Ausgang eines ersten taktgesteuerten Spannungsverdopplers BS1 und das Gate des zweiten Transistors T2 durch den Ausgang eines zweiten Spannungsverdopplers BS2 gesteuert.

Der Eingang e des einzelnen Spannungsverdopplers BS1 bzw. BS2 usw. ist durch den Sourceanschluss eines ersten MOS-Feldeffekttransistors t1 vom selbstsperrenden Typ gegeben, dessen Gate durch ein erstes Taktsignal $\Phi_1$ gesteuert ist und dessen Drainanschluss am Eingang eines Inverters i liegt. Der Ausgang des Inverters i ist mit einem Knoten verbunden. Von diesem Knoten führt ein erster Weg zu dem einen Eingang eines ersten NOR-Gatters a1. Dieser Weg ist durch die Source-Drainstrecke eines zweiten selbstsperrenden MOS-Feldeffekttransitors t2 gegeben, der dem ersten Transistor t1 gleich ist. Der zweite Anschluss des ersten NOR-Gatters n1 liegt unmittelbar an dem besagten Knoten. Ein zweites NOR-Gatter n2 mit zwei Eingängen liegt mit dem einen Eingang ebenfalls unmittelbar an dem genannten Knoten, während an seinem anderen Eingang ein – gleichzeitig zur Steuerung des Gates des zweiten Transistors t2 dienendes – zweites Taktsignal $\Phi_2$ liegt. Schliesslich ist der genannte Knoten noch mit dem Gate eines dritten MOS-Feldeffekttransistors t3 vom selbstsperrenden Typ verbunden, dessen Sourceanschluss am Ausgang des ersten NOR-Gatters n1 und dessen Drainanschluss am Ausgang a" des Spannungsverdopplers liegt und dessen Source-Drainstrecke durch einen MOS-Kondensator c überbrückt ist.

Das zweite NOR-Gatter n2 des Spannungsverdopplers steuert mit seinem Ausgang einen vierten selbstsperrenden MOS-Feldeffekttransistor t4, dessen Source am Versorgungspotential $V_{cc}$

der Schaltung und dessen Drain am Ausgang a″ des Spannungsverdopplers liegt.

Das Verhalten der in der Schaltung gemäss Figur 4 verwendeten Spannungsverdoppler BS1, BS2 usw., die alle in der aus Figur 4a ersichtlichen Weise aufgebaut sind, ist aus Figur 4b ersichtlich. Die beiden jeden der in der Schaltung vorgesehenen Spannungsverdoppler steuernden Taktimpulse $\Phi_1$ und $\Phi_2$ sind zueinander inverse Impulse. Die Dauer der einzelnen Impulse $\Phi_1$ und $\Phi_2$ ist merklich kürzer als die Dauer des an den Eingang e gelegten Signals. Erscheint während der Anwesenheit des Impulses $\Phi_1$ am Eingang e des Spannungsverdopplers eine logische «1», so geht der Ausgang von n2 sofort nach logisch «1», während wegen des mit $\Phi_2$ = «0» gesperrten Transfertransistors t2 der Ausgang von n1 auf «0» bleibt. Der Transistor t4 ladet damit den Kondensator c vor. Hat dagegen $\Phi_2$ den Pegel logisch «1» so geht auch der Ausgang von n1 auf logisch «1», wodurch die Ausgangsspannung a über die kapazitive Kopplung mit c verdoppelt wird. Erscheint während der Dauer eines Impulses $\Phi_1$ am Eingang e eine logische «0» so gehen die Ausgänge von n1 und n2 sofort auf den Pegel «0», wodurch der Kondensator c über den Transistor t3 entladen wird.

Bei der in Figur 4 dargestellten Anschaltung des zur Steuerung des ersten MOS-Feldeffekttransistors T1 vorgesehenen Spannungsverdopplers BS1 wird dessen Eingang durch einen weiteren Inverter i1 beaufschlagt, während sein Ausgang a″ am Gate von T1 liegt. Im Falle des Spannungsverdopplers BS2 ist der Eingang e unmittelbar an den Ausgang eines NOR-Gatters N angeschlossen, der ausserdem zur Beaufschlagung des Eingangs des Inverters I1 dient, so dass die beiden Spannungsverdoppler BS1 und BS2 an ihrem Eingang e invers zueinander durch das NOR-Gatter N gesteuert sind.

Das NOR-Gatter N hat sieben Eingänge. Davon werden zwei durch den Ausgang je eines UND-Gatters U1 bzw. U2 beaufschlagt, die ihrerseits – ebenso wie die restlichen Eingänge des NOR-Gatters N – an durch externe Signale beaufschlagte Signaleingänge 1–9 angeschlossen sind, deren jeweilige Signale von der Wandlersteuerung WST geliefert werden. Einzelheiten hinsichtlich der Beaufschlagung der Eingänge 1 bis 9 werden im Anschluss an die Beschreibung der Schaltung gemäss Figur 4 noch gebracht.

Das NOR-Gatter N, die zu seiner Beaufschlagung vorgesehenen beiden UND-Gatter U1 und U2, der Inverter I1, die beiden Spannungsverdoppler BS1 und BS2 und die beiden Transistoren T1 und T2 bilden die einzelne Vergleichsstufe im Analog-Digitalwandler ADW zusammen mit dem jeweils zugehörigen Kondensator $KW_v$ im Kapazitätsnetzwerk PN. Da die Bitwertigkeit (n+1) ist und demgemäss (n+2) Vergleichsstufen vorgesehen sind, ist der bisher beschriebene Teil der Schaltung gemäss Figur 4 insgesamt (n+2)-mal vorgesehen. Die übrigen Teile der Schaltung gemäss Figur 4 sind im Gegensatz hierzu nur einmal vorhanden.

Der durch den Ausgang 0 des Kapazitätsnetzwerks PN beaufschlagte Differenzverstärker DV ist bei der in Figur 4 dargestellten Ausbildung der Erfindung durch eine kapazitiv gekoppelte Inverterkette gegeben. Dabei liegt der Ausgang 0 von PN im Differenzverstärker DV einerseits an der Source eines Transistors T3, dessen Drain am Anschluss b* für das äussere Referenzpotential REF* liegt, und dessen Gate über einen weiteren Signaleingang 10 gesteuert ist. Anderseits liegt der Ausgang von PN an dem einen Anschluss eines Kondensators C1, dessen zweiter Anschluss mit dem Eingang eines – von einem weiteren MOS-Feldeffekttransistor T4 vom Typ der bisher genannten Transistoren überbrückten – Inverters i2 gelegt ist. Der Ausgang des zuletzt genannten Inverters i2 liegt am einen Anschluss eines weiteren Kondensators C2, während das Gate seines Überbrückungstransistors T4 durch einen Signaleingang 11 gesteuert ist.

Der zuletzt genannte Kondensator C2 stellt die Verbindung zu einem – ebenfalls von einem MOS-Feldeffekttransistor T5 überbrückten – weiteren Inverter i3 dar. Zur Steuerung des Gates des Transistors T5 ist ein weiterer Eingang 12 vorgesehen. Der Ausgang des zweiten Inverters i3 des Differenzverstärkers DV ist über einen weiteren Kondensator C3 mit dem Eingang eines weiteren Inverters i4 verbunden, der ebenfalls mit einem Überbrückungstransistor T6 versehen ist. Dabei ist der Überbrückungstransistor T6 des den Ausgang des Differenzverstärkers DV bildenden Inverters i4 an seinem Gate durch einen weiteren Signaleingang 13 der Schaltung gesteuert. Sowohl der Ausgang als auch der Eingang des zuletzt genannten Inverters i4 stehen in Verbindung zu jedem der beiden Schaltungsteile A1 und A2, die ihrerseits das innere Fusspunktspotential GND und das innere Referenzpotential REF liefern. Ausserdem dient der Ausgang des Inverters i4 zur Steuerung des Komparator-Flip-Flops KP.

Der Eingang des Komparators KP wird durch den einen stromführenden Anschluss eines weiteren MOS-Feldeffekttransistors T7 gebildet, dessen Gate durch einen Signaleingang 14 gesteuert ist, während sein Drain am Eingang einer aus zwei Invertern i5 und i6 gebildeten und von einem weiteren MOS-Feldeffekttransistor T8 überbrückten Inverterkette liegt. Für den Transistor T8 ist zwecks der Steuerung seines Gates ein weiterer Signaleingang 15 vorgesehen. Der Ausgang des zweiten Inverters i6 der genannten Inverterkette i5, i6 liegt am Gate eines weiteren MOS-Feldeffekttransistors T9, dessen Drain an das Versorgungspotential $V_{CC}$ angeschlossen ist und dessen Source einerseits den Ausgang des Komparators KP bildet und andererseits unmittelbar über einen weiteren MOS-Feldeffekttransistor T10, der durch einen Schaltungspunkt zwischen den beiden Invertern i5 und i6 gesteuert ist, mit dem Bezugspotential $V_{SS}$ der Schaltung verbunden ist. Die Schaltung für den Komparator KP wirkt als D-Flip-Flop mit nachfolgendem Ausgangstreiber, wie noch näher beschrieben wird. Sein Ausgang liegt an der nur in Fig. 2 angedeuteten Wandlersteuerung WST, die in üblicher Weise ausgestaltet sein kann.

Der Schaltungsteil A1, der für die Erzeugung des programmierten internen Fusspunktspotentials GND zuständig ist, liegt mit seinem Eingang unmittelbar am Ausgang des Inverters i4 des Differenzverstärkers DV. Dieser Eingang von A1 ist durch den einen stromführenden Anschluss eines MOS-Feldeffekttransistors T11 gegeben, dessen Gate von einem Signaleingang 15 gesteuert ist und dessen zweiter stromführender Anschluss einerseits über einen Kondensator C4 mit dem Anschluss für das externe Fusspunktspotential GND* und andererseits mit dem Gate zweier weiterer Transistoren vom Typ der bisher genannten Transistoren, nämlich der selbstsperrenden Transistoren T12 und T13, verbunden ist. Der eine dieser beiden Transistoren, nämlich der Transistor T12, liegt mit seiner Source am Bezugspotential $V_{SS}$ und mit seinem Drain einerseits am Sourceanschluss eines selbstleitenden MOS-Transistors $T_1^*$ und andererseits am Gate eines weiteren selbstsperrenden MOS-Transistors T14, der mit seinem Sourceanschluss ebenfalls am Bezugspotential $V_{SS}$ liegt.

Das Gate des selbstleitenden Transistors $T_1^*$ im Schaltungsteil A1 ist mit dem Drainanschluss des zuletzt genannten MOS-Feldeffekttransistors T14 und dem Sourceanschluss des vorher genannten und unmittelbar am Eingangstransistor T11 mit seinem Gate liegenden Transistors T13 verbunden. Der Drainanschluss dieses Transistors T13 sowie der Drainanschluss des selbstleitenden Transistors $T_1^*$ liegt an der Klemme für das Versorgungspotential $V_{CC}$ der Schaltung. Der durch einen Schaltungspunkt zwischen den beiden Transistoren T13 und T14 im Schaltungsteil A1 gegebene Ausgang a desselben ist über einen Transistor T15 vom selbstsperrenden Typ mit dem Eingang des letzten Inverters i4 des Differenzverstärkers DV verbunden, dessen Gate durch den Signaleingang 2 gesteuert ist. Der Ausgang a des Schaltungsteils A1 dient in noch zu beschreibender Weise zur Beaufschlagung des Schaltwerks SW2.

Der zur Erzeugung des internen Referenzpotentials REF dienende Schaltungsteil A2 hat einen ähnlichen Aufbau wie der soeben beschriebene Schaltungsteil A1. Sein durch einen selbstsperrenden Transistor T16 gegebener Eingang liegt ebenfalls wie der ihm entsprechende Transistor T11 in A1 am Ausgang des Inverters i4 des Differenzverstärkers DV. Der zweite stromführende Anschluss des Transistors T16 ist über den Speicherkondensator C5 mit dem externen Fusspunktspotential GND* verbunden und liegt ausserdem am Gate eines dem Transistor T12 in A1 entsprechenden Transistors T17 sowie am Gate eines dem Transistor T13 entsprechenden Transistors $T_2^*$, der jedoch im Gegensatz zu T13 selbstleitend ist. Demzufolge ist der Transistor T17 mit seiner Source an das Bezugspotential $V_{SS}$ und an seinem Drain an der Source eines die Stelle des Transistors $T_1^*$ im Schaltungsteil A1 einnehmenden Transistors T18, der jedoch im Gegensatz zu

$T_1^*$ vom selbstsperrenden Typ ist. Der Drain von T18 liegt am Versorgungspotential $V_{CC}$. Ausserdem liegt ein Schaltungspunkt T17 und T18 am Gate eines dem Transistor T14 in A1 entsprechenden und mit seinem Sourceanschluss an der Klemme für das Bezugspotential $V_{SS}$ gelegten MOS-Feldeffekttransistors T19, der unter Vermittlung des bereits genannten und durch den Eingangstransistor T16 gesteuerten Transistors $T_2^*$, an das Versorgungspotential $V_{CC}$ angeschlossen ist. Ein Schaltungspunkt zwischen $T_2^*$ und T19 dient sowohl als Ausgang b des Schaltungsteils A2 als auch zur Steuerung des Gates des Transistors T18. Der Ausgang b des Schaltungsteils A2 ist über die Source-Drainstrecke eines selbstsperrenden Transistors T20 an den Eingang des Inverters i4 im Differenzverstärker DV gelegt. Dieser Transistor T20 wird an seinem Gate durch das über den Signaleingang 3 zugeführte Signal gesteuert, während zur Steuerung des Gates des Eingangstransistors T16 von A2 ein weiterer Eingang 16 vorgesehen ist.

Die in Figur 4 dargestellte Ausgestaltung des Schaltwerks SW2 hat die Aufgabe, die an ihren Eingängen a, b, a* und b* sowie $e_0 \ldots e_m$ (= Eingänge AES in Fig. 1 und Fig. 2) angelegten Potentiale auf die Ausgangspotentialleitungen a', b' durchzuschalten. Zu diesem Zweck ist b' über die stromführende Strecke des Transistors T23 mit dem Ausgang b des Schaltungsteils A2, über den Transistor T24 mit dem Ausgang a des Schaltungsteils A1, über den Transistor T25 mit dem externen Referenzpotentialeingang b* sowie über je einen Transistor T* vom selbstsperrenden Typ mit je einem der analogen Eingangspotentiale $e_0, \ldots e_m$ verbunden. Die Potentialleitung a' ist über die stromführende Strecke des Transistors T21 mit dem Ausgang a des Schaltungsteils A1 und über den Transistor T22 mit dem externen Fusspunktpotentialeingang a* verbunden.

Die Gates von allen diesen Transistoren T21–T25 und T* werden von dem Ausgang je einer Spannungsverdopplerschaltung nach Figur 4a angesteuert, und zwar T23 von BS3, T24 von BS4, T25 von BS5, T21 von BS6, T22 von BS7 sowie jeder Transistor T* von einem zugehörigen Spannungsverdoppler BS*.

Die Eingänge dieser Spannungsverdopplerschaltungen e sind durch Steuersignale beaufschlagt, die von der Wandlersteuerung WST geliefert werden. Dabei ist folgende Zuordnung vorgesehen:

Der Eingang von BS3 wird durch eine ODER-Verknüpfung OD vom Steuersignal am Signaleingang 4 (SPRF – Sample REF) und dem Steuersignal 17 (IREF – Internal REF) beaufschlagt.

Der Eingang von BS4 wird durch durch das Steuersignal 5 (SPGND – Sample Ground) gesteuert.

Der Eingang von BS5 wird durch das Steuersignal 18 (EREF – External REF) beaufschlagt.

Der Eingang von BS6 liegt an dem Steuersignal 21 (IGND – Internal Ground).

Der Eingang e am Steuersignal 22 (EGND – External Ground).

Die Eingänge der BS* werden jeweils unter Vermittlung einer UND-Verknüpfung UN vom Steuersignal 1 (PRAX – Precharge Analog Input) mit jeweils einem der Steuersignale 19* (CAN$_i$ – Convert Analog Input i) beaufschlagt.

Die Steuersignale 1, 4 und 5 dienen gleichzeitig der Steuerung des Schaltwerks SW1 und beaufschlagen, wie oben angedeutet, einige Eingänge des NOR-Gatters N.

Zum Schluss ist noch auf die Beaufschlagung der sieben Eingänge dieser NOR-Gatter N in SW1 einzugehen. Wie bereits oben erwähnt, liegt ein erster Eingang von N am Signaleingang 5, ein zweiter Eingang von N am Signal 4 und ein dritter Eingang von N am Signal 1, wobei die genannten Signaleingänge gleichzeitig zur Beaufschlagung von SW2 vorgesehen sind. Ein weiterer Signaleingang 6 der Schaltung dient zur Beaufschlagung eines vierten Eingangs von N. Dasselbe gilt für den Signaleingang 7. Die beiden restlichen Eingänge des NOR-Gatters N ist durch jeweils ein UND-Gatter U1 bzw. U2 gesteuert, wobei die beiden Eingänge des UND-Gatters U1 am zweiten Signaleingang 2 bzw. am achten Signaleingang 8 der Schaltung liegen. Der eine Eingang von U2 liegt am Signaleingang 3 und der andere Eingang von U2 am Signaleingang 9 der Schaltung. In diesem Zusammenhang wird nochmals daran erinnert, dass der Signaleingang 2 noch zur Steuerung des Transistors T15 im Schaltungsteil A1 und der Signaleingang 3 zur Steuerung des Transistors T20 im Schaltungsteil A2 vorgesehen ist.

Vor der Beschreibung der Betriebsweise der in Fig. 3 und 4 dargestellten Ausführungsform der Erfindung wird noch eine Tabelle der für die Signalbeaufschlagung der aus den beiden Figuren ersichtlichen Signaleingänge gebracht:

Der Signaleingang 1 wird mit dem Signal PRAX (Precharge Analog Input) gesteuert;

der Signaleingang 2 wird mit dem Signal PRGD (Precharge Ground) beaufschlagt;

der Signaleingang 3 wird durch das Signal PREF (Precharge REF) und

der Signaleingang 4 durch das Signal SPEF (Sample REF) beaufschlagt;

am Signaleingang 5 SPGD (Sample Ground).

Die Steuersignale 1–5 beaufschlagen gleichzeitig alle (n+2) NOR-Gatter N in den (n+2) Stufen des Schaltwerks SW1. Wie oben bereits festgestellt, beaufschlagen die Steuersignale 1, 4 und 5 gleichzeitig das Schaltwerk SW2 und die Steuersignale 2 und 3 die Schaltungsteile A1 und A2.

Dagegen sind die Steuersignale 6–9 jeweils einmal für jede der (n+2) Stufen vorgesehen. Sie stellen jeweils das betreffende Bit $\nu$ eines von der Wandlersteuerung bereitgestellten und (n+1) Bit breiten Digitalwortes dar. Im einzelnen wird das Steuersignal 6 durch das Signal BIT beaufschlagt, das bei A/D-Wandlung gemäss dem Verfahren der sukzessiven Approximation das jeweils behandelte Bit anzeigt. Steuersignal 7 ist durch das Signal RSDT$_\nu$ (Bit $\nu$ des Registers Result Data) gegeben, während der Signaleingang 8 durch das Signal GDDT$_\nu$ (Bit $\nu$ des Registers Ground Data) und der Signaleingang 9 durch das

Signal RFDT$_\nu$ (Bit $\nu$ des Registers Reference Data) beaufschlagt ist.

Die Eingänge 6–9 des NOR-Gatters N der letzten Stufe S im Schaltwerk SW1 (Fig. 3) sind sämtlich mit logisch «0» beaufschlagt.

Der Eingang 10 im Differenzverstärker DV wird mit PRDA1 (Precharge Differential Amplifier 1), der Eingang 11 im Differenzverstärker DV mit PRD A 2 (Precharge Differential Amplifier 2), der Eingang 12 im Differenzverstärker DV mit PRDA3 (Precharge Differential Amplifier 3) und der Eingang 13 mit PRDA4 (Precharge Differential Amplifier 4) beaufschlagt.

Der Eingang 14 im Komparator KP wird durch LDKP (Load Comparator) und der Eingang 14a durch $\overline{\text{LDKP}}$ (Load Comparator invertiert) gesteuert. Der Ausgang des Komparators KP ist mit A* bezeichnet und liegt an der in Fig. 4 nicht dargestellten Wandlersteuerung WST.

Der Eingang 15 in dem Schaltungsteil A1 wird durch das Signal $\overline{\text{HDGD}}$ (Hold Ground invertiert) und der Eingang 16 im Schaltungsteil A2 durch das Signal $\overline{\text{HDRF}}$ (Hold Reference invertiert) gesteuert.

Der Eingang 17 im Schaltwerk SW2 wird durch das Signal IRF (Internal Reference), der Eingang 18 durch das Signal ERF (External Reference), der Eingang 21 durch das Signal IGD (Internal Ground) und der Eingang 22 durch das Signal EGD (External Ground) beaufschlagt. Jeder der vorgesehenen Eingänge 19* wird durch ein spezifisch auf den diesem Eingang zugeordneten analogen Eingang e$_\mu$ ausgerichtetes Signal CAN$_\mu$ (Convert Analog Input $\mu$) beaufschlagt.

Es kann nun im Zusammenhang mit der Schaltung gemäss Figur 3 und 4 folgendes festgestellt werden:

Die komplette Analog-Digitalwandlung im Wandler ADW geschieht in drei Stufen:

1. In der ersten Stufe findet die Digital-Analogwandlung eines vom Mikroprozessor MP in das entsprechende Register der Wandlersteuerung WST geschriebenen Binärworts (z.B. bei einer Auflösung von 8 Bit im Wandler ADW die Binärworte RFDT$_7$, RFDT$_6$, ... RFDT$_1$, RFDT$_0$) (liegt an den Signaleingängen 8) zum analogen Potential REF unter Verwendung des externen Referenzpotentials REF* und des externen Fusspunktspotentials GND* statt. Das Potential REF wird im Schaltungsteil A2 analog gespeichert.

2. Im zweiten Schritt erfolgt die Digital-Analogwandlung eines vom Mikroprozessor MP an das entsprechende Register der Wandlersteuerung WST gelieferten Binärworts (GDDT$_7$, GDDT$_6$, ... GDDT$_1$, GDDT$_0$) (wird an den Signaleingängen 9 angelegt) zum analogen Potential GND unter Verwendung der externen Potentiale GND* und REF*. Das Potential GND wird im Schaltungsteil A1 analog gespeichert.

3. Im dritten Schritt findet die Analog-Digitalwandlung eines der an den analogen Signaleingängen e$_1$, ... e$_m$ angelegten analogen Potentials ANA$_0$, ANA$_1$ ... ANA$_m$ aufgrund einer vom Mikroprozessor MP getroffenen Auswahl unter Verwendung der gemäss Schritt 1 und Schritt 2 generierten Potentiale GND und REF statt.

Im einzelnen laufen die drei Schritte folgendermassen ab:

Zu 1.: Zunächst werden in einer Vorladephase (Precharge) die Nullpunktsabweichungen (Offsets) in den Verstärkerstufen i2, i3, i4 abgeglichen, sowie das vorgegebene Binärwort ($RFDT_7$, $RFDT_6$, ... $RFDT_1$, $RFDT_0$,) auf das Kapazitätsnetzwerk PN geladen.

Hierzu werden die Eingänge der Inverterstufen i2, i3 und i4 des Differenzverstärkers DV durch die auf die Eingänge 11 und 12 gegebenen Steuersignale mit dem Pegel logisch «1» auf ihre Arbeitspunktspotentiale eingestellt. Die letzte Inverterstufe i4 wird mittels der Signale $\overline{HDRF}$ = «1» (Steuersignal 16) und $\overline{PRRF}$ = «1» (Steuersignal 3) ($\overline{HDRF}$ = $\overline{HOLD\ REF}$; $\overline{PRRF}$ = Precharge REF) über die im Schaltungsteil A2 vorgesehenen Analogspeicher und Treiber für REF rückgekoppelt. Die gemeinsame Seite des Kapazitätsnetzwerks PN wird währenddessen durch das Signal PRDA1 (Steuersignal 10) = «1» mit dem Anschluss b* für das externe Referenzpotential REF* verbunden. Ausserdem werden die Eingänge a', b' über das Schaltwerk SW2 durch die an den Signaleingängen 17 bzw. 22 zugeführten Signale ERF = «1» bzw. EGD = «1» mit dem externen Referenzpotential REF* bzw. Fusspunktspotential GND* beaufschlagt.

Mit Hilfe des Signals PRRF (Steuersignal 3) = «1» werden alle nichtgemeinsamen Seiten derjenigen Kondensatoren $KW_v$ im Netzwerk PN mit der Potentialleitung b' verbunden, die über SW2 auf REF* liegt, bei denen der entsprechende Bitwert $RFDT_v$ des Binärwerts ($RFDT_7$, $RFDT_6$, ... $RFDT_1$, $RFDT_0$) auf «1» liegt, während die restlichen Kondensatoren im Kapazitätsnetzwerk PN durch den zugehörigen Umschalter mit der Potentalleitung a' verbunden werden, die über SW2 auf GND* liegt. Das Kapazitätsnetzwerk PN erhält damit die Ladung

$$K \cdot (REF^* - GND^*) + \sum_{v=0}^{7} 2^v \cdot K \cdot (REF^* - GND^*) \cdot (1 - RFDT_v).$$

Die Koppelkapazität C1 zum Differenzverstärker DV speichert den Potentialunterschied zwischen dem externen Referenzpotential REF* und dem Arbeitspunkt der ersten Inverterstufe $i_2$, während die Koppelkapazitäten C2, C3 zwischen den Inverterstufen i2, i3, i4 den Unterschied der Arbeitspunkte der durch sie verbundenen Stufen enthalten.

In der nachfolgenden Einstellphase wird durch Abschalten der Vorladesignale PRRF (Steuersignal 3) = «0» und ERF (Steuersignal 18) = « » sowie durch Einschalten des Signals SPRF (Steuersignal 4) = «1» (= Sample REF) bei Verbleiben von $\overline{HDRF}$ (Steuersignal 16) auf dem Pegel «1» die nichtgemeinsame Seite aller Kondensatoren KW des Kapazitätsnetzwerks PN mit der Potentialleitung b' verbunden, die ihrerseits über das Schaltwerk SW2 mit dem Ausgang b des Schaltungsteils A2 verbunden ist. Damit wird der Differenzverstärker DV über A2, SW2, SW1 und das Kapazitätsnetzwerk PN vollständig gegengekoppelt und stellt sich so ein, dass der Eingang der ersten verstärkenden Inverterstufe i2 in DV wieder an dem vorher eingestellten Arbeitspunkt liegt. Das Potential der den Ausgang O von PN bildenden gemeinsamen Seite der Kapazitäten KW im Kapazitätsnetzwerk ist damit wieder auf dem Wert REF* und die in diesen Kondensatoren KW gespeicherte Ladung verteilt sich nun gleichmässig, so dass

$$K \cdot 2^8 (REF^* - REF) = K \cdot (REF^* - GND^*) + \sum_{v=0}^{7} K\,2\,(REF^* - GND^*) \cdot (1 - RFDT_v)$$

oder

$$REF^* - REF = 1/2^8 \cdot (REF^* - GND^*) \cdot \left(1 + \sum_{v=0}^{7} 2^v \cdot (1 - RFDT_v)\right)$$

und somit

$$REF - GND^* = (REF^* - GND^*) \left(\sum_{v=0}^{7} (2^{v-8}\,RFDT_v)\right)$$

gilt. (Die Werte beziehen sich auf den Fall der Datenbreite von 8 Bit.)

Durch das Signal $\overline{HDRF}$ (Steuersignal 16) = «0» wird nun das zum Erreichen dieses analogen Potentials REF am Ausgang von A2 benötigte Eingangspotential der Treiberstufe $T_2^*$, T17, T18 und T19 im Schaltungsteil A2 auf deren Speicherkondensator C5 eingesperrt, so dass dieses Potential REF für den späteren Gebrauch im Schritt 3 zur Verfügung steht.

Zu 2.: Das vom Schaltungsteil A1 gelieferte analoge Fusspunktspotential GND wird auf die gleiche Weise bereitgestellt. In der Vorladephase wird durch das Signal PRGD (Steuersignal 2) = «1» (= Precharge Ground) der Binärwert ($GDDT_n$, ... $GDDT_0$ (= Ground Data) auf die nichtgemeinsame Seite des Kapazitätsnetzwerks PN gegeben, während die Analogspeicher-Treiberstufe A1 für die Erzeugung des internen Fusspunktspotentials GND zusammen mit der letzten Inverterstufe i4 des Differenzverstärkers DV abgeglichen wird. In der Einstellphase wird durch das Signal SPGD (Steuersignal 5) = «1» (= Sample Ground) der Ausgang a des Schaltungsteils A2 mit der Potentialleitung b' verbunden, so dass nach Abschalten des Signals HDGD (Steuerleitung 15) = «0» (= Hold Ground invertiert) auf der Speicherkapazität C4 im Schaltungsteil A1 ein Potential eingesperrt wird, das am Ausgang der Treiberstufe in A1 das interne Fusspunktspotential GND definiert, das sich nach der Geichung

$$GND - GND^* = (REF^* - GND^*) \left( \sum_{v=0}^{7} (2^{v-8} GDDT_v) \right)$$

ergibt.

Zu 3.: Die nun folgende Analog-Digitalwandlung verläuft entsprechend den Ausführungen der Literaturstelle «Siemens Forschungs- und Entwicklungsberichte», Bd. 8 (1979) Nr. 5, S. 262. Als einziger Unterschied ist dabei die Tatsache zu vermerken, dass dort das externe Fusspunktspotential GND* sowie das externe Referenzpotential REF* für die Wandlung verwendet werden, während im vorliegenden Fall die in den Schaltungsteilen A1 und A2 generierten internen Potentiale REF und GND für die Wandlung eingesetzt werden. Diese Potentiale werden durch die von der Wandlersteuerung gelieferten Signale IRF (Steuersignal 17) und IGD (Steuersignal 21) auf die Eingänge b' bzw. a' des Schaltwerks SW1 gebracht.

Der genannte Unterschied führt aber dazu, dass man bei der Erfindung mit einem Analog-Digitalwandler ADW mit mässigem Aufwand an Vergleichsstufen, insbesondere mit einem Wandler mit 8 Stufen, auskommt und dennoch eine erhebliche Anzahl von Spannungsbreiten für die zu verarbeitenden Analogsignale beherrschen kann. Auf konventionelle Weise wäre hierzu ein Wandler mit höherer Stufenzahl (z.B. 10–12) erforderlich.

**Patentansprüche**

1. Integrierte Halbleiterschaltung
   - mit einem Mikroprozessor (MP),
   - mit einem Analog-Digitalwandler (ADW),
   - der wenigstens einen Eingang für je ein externes, analoges, zu digitalisierendes Eingangssignal (e0 bis em; AES) aufweist,
   - der über Steuereingänge (SE$_{AD}$) mit dem Mikroprozessor (MP) verbunden ist, über die der Analog-Digitalwandler (ADW) durch den Mikroprozessor (MP) steuerbar ist.
   - der ausserdem über Ausgänge (A) mit dem Mikroprozessor (MP) verbunden ist, über die aus jeweils einem analogen Eingangssignal (e0 bis em; AES) mittels des Analog-Digitalwandlers (ADW) gewonnene digitale Ausgangssignale dem Mikroprozessor (MP) übermittelbar sind,
   - der Analog-Digitalwandler (ADW) enthält ein Präzisionsnetzwerk (PN), einen Differentialverstärker (DV) und wenigstens zwei Schaltwerke (SW1, SW2), die insgesamt sowohl der Analog-Digitalwandlung als auch einer Digital-Analogwandlung dienen,
   - mit einer Schaltung (DAW),
   - die die Funktion eines Digital-Analogwandlers aufweist,
   - die ebenfalls über Steuereingänge (SE$_{DA}$) mit dem Mikroprozessor (MP) verbunden ist und durch diesen steuerbar ist,
   - die Schaltung (DAW) weist zwei Eingänge (a*, b*) auf,
   - der eine Eingang (a*) ist mit einem externen Fusspunktpotential (GND*) verbunden,
   - der andere Eingang (b*) ist mit einem externen Referenzpotential (REF*) verbunden,
   - zwischen dem externen Referenzpotential (REF*) und dem externen Fusspunktspotential (GND*) ist eine externe Referenzspannung (U*$_{ref}$) ausgebildet,
   - die Schaltung (DAW) weist zwei Ausgänge (a', b') auf, die mit dem Analog-Digitalwandler (ADW) verbunden sind,
   - der eine Ausgang (a') weist ein internes Fusspunktspotential (GND) auf,
   - der andere Ausgang (b') weist ein internes Referenzpotential (REF) auf,
   - zwischen dem internen Referenzpotential (REF) und dem internen Fusspunktspotential (GND) ist eine interne Referenzspannung (U$_{ref}$) ausgebildet,
   - die Schaltung (DAW) enthält zwei Schaltungsteile (A1, A2) mit Digital-Analogwandlerfunktion,
   - der eine Schaltungsteil (A1) dient der Einstellung des internen Fusspunktspotentials (GND), er weist dazu einen Ausgang (a) auf,
   - der andere Schaltungsteil (A2) dient der Einstellung des internen Referenzpotentials (REF), er weist dazu ebenfalls einen Ausgang (b) auf,
   - das Präzisionsnetzwerk (PN) ist als Kapazitätsnetzwerk mit digital gewichteten Kondensatoren (KW$_i$, i = 0 ... n) gestaltet,
   - die Kondensatoren (KW$_i$) des Präzisionsnetzwerkes (PN) sind alle auf einer Seite fest miteinander verbunden,
   - die andere Seite jedes der Kondensatoren (KW$_i$) ist über die Schaltwerke (SW1, SW2) einzeln wahlweise mit dem externen Referenzpotential (REF*), mit dem externen Fusspunktspotential (GND*), jedem der zu digitalisierenden externen analogen Eingangssignale (e0 ... em; AES), mit dem Ausgang (a) des einen Schaltungsteils (A1), der der Einstellung des internen Fusspunktspotentials (GND) dient und mit dem Ausgang (b) des anderen Schaltungsteils (A2), der der Einstellung des internen Referenzpotentials (REF) dient, verbindbar.

2. Integrierte Halbleiterschaltung nach Anspruch 1 oder 3, dadurch gekennzeichnet, dass die zur Erzielung der Digital-Analogwandlerfunktionen dienenden Schaltungsteile (A1, A2) jeweils einen Analogspeicher (c) und einen Treiber (T) enthalten.

3. Integrierte Halbleiterschaltung nach einem der Ansprüche 1 oder 2, dadurch gekennzeichnet, dass der Differenzverstärker (DV) an seinem einen Eingang mit dem Ausgang (0) des Präzisionsnetzwerks (PN) verbunden und an seinem anderen Eingang mit einem der die externe Referenzspannung (U*$_{ref}$) definierenden Potential (REF*, GND*) beaufschlagt ist.

4. Integrierte Halbleiterschaltung nach Anspruch 3, dadurch gekennzeichnet, dass der Differenzverstärker (DV) als kapazitätsgekoppelte Inverterkette (i2, i3, i4) ausgeführt ist, bei der in einer Vorladephase die Arbeitspunkte der einzelnen Stufen (i2, i3, i4) durch Verbinden des Eingangs mit dem Ausgang jeder einzelnen Stufe eingestellt werden, wobei die Unterschiede der einzelnen Arbeitspunkte auf den die einzelnen Stufen jeweils verbindenden Kondensatoren (C2, C3) gespeichert werden, dass dabei der Eingang des ersten Inverters (i2) über einen Kondensator (C1) an den Ausgang (0) des Präzisionsnetzwerks (PN) gekoppelt ist und dass dieser Ausgang (0) während der genannten Vorladephase über einen Transistor (T3) auf ein externes Referenzpotential (b*) vorgeladen wird, so dass der Unterschied zwischen diesem Referenzpotential und dem Arbeitspunkt der ersten Inverterstufe (i2) auf diesem Kondensator (C1) gespeichert wird.

5. Integrierte Halbleiterschaltung nach Anspruch 4, dadurch gekennzeichnet, dass die Arbeitspunkteinstellung der letzten Inverterstufe (i4) wahlweise durch direktes Verbinden von Eingang und Ausgang (über T6) oder durch Verbinden des Ausgangs der letzten Inverterstufe (i4) mit deren Eingang unter Vermittlung des der Erzeugung des internen Fusspunktspotentials (GND) dienenden Schaltungsteils (A1; über T11 und T15) oder durch Verbinden des Ausgangs des letzten Inverters (i4) mit seinem Eingang unter Vermittlung des der Erzeugung des internen Referenzpotentials (REF) dienenden Schaltungsteils (A2; über T16 und T20) erfolgt.

6. Integrierte Halbleiterschaltung nach Anspruch 2, dadurch gekennzeichnet, dass der Treiber (T) in dem der Erzeugung des internen Fusspunktspotentials (GND) dienenden Schaltungsteils (A1) aus drei selbstsperrenden MOS-Feldeffekttransistoren (T12, T13, T14) und einem selbstleitenden Transistor (T$_1^*$) besteht.

7. Integrierte Halbleiterschaltung nach Anspruch 2, dadurch gekennzeichnet, dass der Treiber (T) in dem der Erzeugung des internen Referenzpotentials (REF) dienenden Schaltungsteil (A2) aus drei selbstsperrenden MOS-Feldeffekttransistoren (T17, T18, T19) und einem selbstleitenden MOS-Feldeffekttransistor (T$_2^*$) besteht.

8. Integrierte Halbleiterschaltung nach einem der vorhergehenden Ansprüche, dadurch gekennzeichnet, dass die Schaltwerke (SW1, SW2) als selbstsperrende Transistorschalter (T1, T2, T21, T22, T23, T24, T25, T*) ausgeführt sind, deren Steuerelektroden über jeweils eine Spannungsverdopplerschaltung (BS1, BS2, BS6, BS7, BS3, BS4, BS5, BS*) angesteuert werden.

9. Integrierte Halbleiterschaltung nach Anspruch 8, dadurch gekennzeichnet, dass zur Realisierung der einzelnen Spannungsverdoppler deren Eingang (e) über einen durch ein erstes Taktsignal (Φ$_1$) gesteuerten Transfertransistor (t1) mit nachgeschaltetem Inverter (i) an einen Knoten gelegt ist, von dem aus erstens die Source-Drainstrecke eines durch zweites Taktsignal (Φ$_2$) gesteuerten Transfertransistors (t2) an den einen Anschluss eines ersten NOR-Gatters (n1) führt, von dem aus zweitens eine unmittelbare Verbindung zu dem einen Eingang eines zweiten NOR-Gatters (n2) besteht, dessen anderer Eingang durch das zweite Taktsignal (Φ$_2$) gesteuert ist, von dem aus drittens eine unmittelbare Verbindung zum zweiten Eingang des ersten NOR-Gatters (n1) führt und von dem aus viertens das Gate eines dritten MOS-Feldeffekttransistors (t3) gesteuert wird, dessen Source-Drainstrecke durch einen Kondensator (c) überbrückt ist und der die Verbindung zwischen dem Ausgang des ersten NOR-Gatters (n1) und dem Ausgang (a'') des Spannungsverdopplers bildet, und dass schliesslich der Ausgang des zweiten NOR-Gatters (n2) zur Steuerung eines weiteren selbstsperrenden MOS-Feldeffekttransistors (t4) dient, der den Ausgang (a'') des Spannungsverdopplers mit dem das Versorgungspotential (V$_{CC}$) führenden Versorgungsanschluss verbindet.

**Revendications**

1. Circuit intégré à semiconducteurs comportant
   – un microprocesseur (MP),
   – un convertisseur analogique/numérique (ADW),
   – qui comporte au moins une entrée pour un signal d'entrée extérieur analogique respectif (e0 à em; AES) devant être numérisé,
   – qui est relié au microprocesseur (MP) par l'intermédiaire d'entrées de commande (SE$_{AD}$), par l'intermédiaire desquelles le convertisseur analogique/numérique (ADW) peut être commandé par le microprocesseur (mP),
   – qui est relié en outre au microprocesseur (MP) par l'intermédiaire de sortie (A), par l'intermédiaire desquelles des signaux de sortie numériques obtenus à partir de signaux d'entrée analogique respectifs (e0 à em; AES) au moyen du convertisseur analogique/numérique (ADW), peuvent être transmis au microprocesseur (MP),
   – le convertisseur analogique/numérique (ADW) contient un réseau de précision (SW), un amplificateur différentiel (DB) et au moins deux unités de commutation (SW1, SW2), qui servent aussi bien à réaliser la conversion analogique/numérique qu'une conversion numérique/analogique,
   – un circuit (DAW),
   – qui possède la fonction d'un convertisseur numérique/analogique,
   – qui est également relié par l'intermédiaire d'entrée de commande (SE$_{DA}$) au microprocesseur (mP) et peut être commandé par ce dernier,
   – le circuit (DAW) comporte deux entrées (a*, b*),
   – une entrée (a*) est reliée à un potentiel extérieur de base (GND*),
   – l'autre entrée (b*) est reliée à un potentiel de référence extérieur (REF*),

– une tension extérieure de référence (U*_{ref}) est formée entre le potentiel extérieur de référence (REF*) et le potentiel de base extérieur (GND*),

– le circuit (DAW) comporte deux sorties (a', b'), qui sont reliées au convertisseur analogique/numérique (ADW),

– une sortie (a') possède un potentiel de base intérieur (GND),

– l'autre sortie (b') comporte un potentiel de référence intérieur (REF),

– une tension de référence interne (U_{ref}) est formée entre le potentiel de référence interne (REF) et le potentiel de base interne (GND),

– le circuit (DAW) contient deux éléments de circuit (A1, A2) ayant une fonction de convertisseur numérique/analogique,

– un élément de circuit (A1) sert à régler le potentiel de base interne (GND) et possède à cet effet une sortie (a),

– l'autre élément de circuit (A2) sert à régler le potentiel de référence interne (REF) et possède à cet effet également une sortie (b),

– le réseau de précision (PN) est réalisé sous la forme d'un réseau capacitif comportant des condensateurs pondérés de façon numérique (KW_i, i = 0 … n),

– les condensateurs (KW_i) du réseau de précision (PN) sont tous reliés entre eux d'un côté de façon fixe,

– l'autre côté de chacun des condensateurs (KW_i) peut être relié individuellement au choix, par l'intermédiaire des unités de commutation (SW1, SW2), au potentiel de référence extérieur (REF*), au potentiel de base extérieur (GND*), à chacun des signaux d'entrée analogiques extérieurs devant être numérisés (e0 … em; AES), à la sortie (a) d'un élément de circuit (A1), qui sert à régler le potentiel de base interne (GND), et à la sortie (b) de l'autre élément de circuit (A27, qui sert à régler le potentiel de référence interne (REF).

2. Circuit intégré à semiconducteurs suivant la revendication 1, caractérisé par le fait que les éléments de circuit (A1, A2) servant à réaliser les fonctions de convertisseur numérique/analogique contiennent chacun une mémoire analogique (C) et un étage d'attaque (T).

3. Circuit intégré à semiconducteurs suivant l'une des revendications 1 ou 2, caractérisé par le fait que l'amplificateur différentiel (DV) est relié par l'une de ses entrées à la sortie (0) du réseau de précision (PN) et est chargé, au niveau de son autre entrée, par un potentiel (REF*, GND*) définissant la tension de référence extérieure (U*_{ref}).

4. Circuit intégré à semiconducteurs suivant la revendication 3, caractérisé par le fait que l'amplificateur différentiel (DV) est réalisé sous la forme d'une chaîne d'inverseurs (i2, i3, i4), couplée par des capacités et dans laquelle, lors d'une phase de charge préalable, les points de fonctionnement des différents états (i2, i3, i4) sont réglés par raccordement de l'entrée à la sortie de chaque étage individuel, les différences entre les différents points de fonctionnement étant mémorisées dans les condensateurs (C2, C3) reliant respectivement les différents étages, que l'entrée du premier inverseur (i2) est accouplée par l'intermédiaire d'un condensateur (C1) à la sortie (0) du réseau de précision (PN) et que cette sortie (0) est préalablement chargée, pendant ladite phase de charge préalable, par l'intermédiaire d'un transistor (T3) à un potentiel de référence extérieur (b*) de sorte que la différence entre ce potentiel de référence et le point de fonctionnement du premier étage inverseur (i2) est mémorisée dans ce condensateur (C).

5. Circuit intégré à semiconducteurs suivant la revendication 4, caractérisé par le fait que le réglage du point de fonctionnement du dernier étage inverseur (i4) s'effectue au choix grâce à un raccordement direct de l'entrée et de la sortie (par l'intermédiaire de T6) ou au moyen du raccordement de la sortie du dernier étage inverseur (i4) à son entrée par l'intermédiaire de l'élément de circuit (A1; par l'intermédiaire de T11 et T15) servant à produire le potentiel de base interne (GND), ou par raccordement de la sortie du dernier inverseur (i4) à son entrée par l'intermédiaire de l'élément de circuit (A2; par l'intermédiaire de T16 et T20) servant à produire le potentiel de référence interne (REF).

6. Circuit intégré à semiconducteurs suivant la revendication 2, caractérisé par le fait que l'étage d'attaque (T) situé dans l'élément de circuit (T1) servant à produire le potentiel de base interne (GND), est constitué par trois transistors à effet de champ MOS auto-bloquants (T12, T13, T14) et par un transistor auto-conducteur (T*_1).

7. Circuit intégré à semiconducteurs suivant la revendication 2, caractérisé par le fait que l'étage d'attaque (T) situé dans l'élément de circuit (A2) servant à produire le potentiel de référence interne (REF) est constitué par trois transistors à effet de champ MOS autobloquants (17, T18, T19) et par un transistor à effet de champ MOS auto-conducteur (T*_2).

8. Circuit intégré à semiconducteurs suivant l'une des revendications précédentes, caractérisé par le fait que les unités de commutation (SW1, SW2) sont réalisées sous la forme de commutateurs à transistors autobloquants (T1, T2, T21, T22, T23, T24, T25, T*), dont les électrodes de commande sont commandées par l'intermédiaire de circuits doubleurs de tension respectifs (BS1, BS2, BS6, BS7, BS3, BS4, BS5, BS*).

9. Circuit intégré à semiconducteurs suivant la revendication 8, caractérisé par le fait que pour réaliser les doubleurs de tension individuels, leur entrée (e) est raccordée par l'intermédiaire d'un transistor de transfert (t1) commandé par un premier signal de cadence (Φ_1) en aval duquel est branché un inveseur (i), à un nœud à partir duquel en premier lieu la voie source-drain d2un transistor de transfert (t2) commandé par un second signal de cadence (Φ_2) est reliée à une première borne d'une première porte NON-ET (n1), et à partir duquel en second lieu une liaison directe est établie avec une première entrée d'une seconde porte NON-ET (n2), dont la seconde entrée est commandée par le second signal de cadence

($\Phi_2$), et à partir duquel en troisième lieu une liaison directe est établie avec la seconde entrée de la première porte NON-ET (n1) et à partir duquel, en quatrième lieu, se trouve réalisée la commande de la porte d'un troisième transistor à effet de champ MOS (t3), dont la voie source-drain est shuntée par un condensateur (c) et qui forme la liaison entre la sortie de la première porte NON-ET (n1) et la sortie (a″) des doubleurs de tension, et qu'enfin la sortie de la seconde porte NON-ET (n2) sert à commander un autre transistor à effet de champ MOS auto-bloquant (t4), qui relie la sortie (a″) du doubleur de tension à la borne d'alimentation appliquant le potentiel d'alimentation ($V_{CC}$).

**Claims**

1. An integrated semiconductor circuit
   - with a microprocessor (MP),
   - with an analogue-digital converter (ADW),
   - having at least one input for an external, analogue input signal which is to be digitalised (e0 to em; AES),
   - control inputs ($SE_{AD}$) connected to the microprocessor (MP) via which the analogue-digital converter (ADW) can be controlled by the microprocessor (MP),
   - outputs (A) connected to the microprocessor (MP) via which digital output signals, in each case derived from an analogue input signal (e0 to em; AES) by means of the analogue-digital converter (ADW) can be transferred to the microprocessor (MP),
   - the analogue-digital converter (ADW) containing a precision network (PN), a differential amplifier (DV) and at least two sequential switching circuits (SW1, SW2) which together effect both analogue-digital conversion and digital-analogue conversion,
   - and with a circuit (DAW),
   - which has the function of a digital-analogue converter,
   - which is likewise connected to the microprocessor (MP) via control inputs ($SE_{AD}$) by which it can be controlled,
   - the circuit having two inputs (a*, b*) where,
   - the first input (a*) is connected to an external base potential (GND*),
   - the other input (b*) is connected to an external reference potential (REF*),
   - an external reference voltage ($U^*_{ref}$) being formed between the external reference potential (REF*) and the external base potential (GND*),
   - the circuit (DAW) having two outputs (a′, b′) connected to the analogue-digital converter (ADW), where
   - the first output (a′) carries an internal base potential (GND),
   - the other output (b′) carries an internal reference potential (REF),
   - an internal reference voltage ($U_{ref}$) being formed between the internal reference potential (REF) and the internal base potential (GND),
   - the circuit (DAW) containing two circuit components (A1, A2) having a digital-analogue converter function,
   - the first circuit component (A1) serving to set the internal base potential (GND) and having an output (a) for this purpose,
   - the other circuit component (A2) serving to set the internal reference potential (REF) and having an output (b) for this purpose,
   - the precision network (PN) consisting of a capacitance network comprising digitally-weighted capacitors ($KW_i$, i = 0...n),
   - the capacitors ($KW_i$) of the precision network (PN) all being permanently connected to one another on one side,
   - the other side of each of the capacitors ($KW_i$) being individually selectively connectable via the sequential switching circuits (SW1, SW2) to the external reference potential (REF*), the external base potential (GND*), each of the external analogue input signals (e0...em; AES) which are to be digitalised, the output (a) of the first circuit component (A1) which serves to set the internal base potential (GND) and the output (b) of the other circuit component (A2) which serves to set the internal reference potential (REF).

2. An integrated semiconductor circuit as claimed in Claim 1, characterised in that the circuit components (A1, A2) which serve to perform the digital-analogue converter functions each contain an analogue store (c) and a driver (T).

3. An integrated semiconductor circuit as claimed in one of Claims 1 or 2, characterised in that the differential amplifier (DV) is connected at its first input to the output (0) of the precision network (PN) and is supplied at its other input with a potential (REF*, GND*) which defines the external reference voltage ($U^*_{ref}$).

4. An integrated semiconductor circuit as claimed in Claim 3, characterised in that the differential amplifier (DV) is formed by a capacitance-coupled inverter chain (i2, i3, i4), where, in a precharge phase, the operating points of the individual stages (i2, i3, i4) where, in a precharge phase, the operating points of the individual stages (i2, i3, i4) are set by connecting the input to the output of each individual stage, where the differences between the individual operating points are stored in the capacitors (C2, C3) which in each case connect the individual stages, that the input of the first inverter (i2) is coupled via a capacitor (C1) to the output (0) of the precision network (PN), and that during the aforesaid precharge phase this output (0) is precharged via a transistor (T3) from an external reference potential (b*), so that the difference between this reference potential and the operating point of the first inverter stage (i2) is stored in this capacitor (C1).

5. An integrated semiconductor circuit as claimed in Claim 4, characterised in that the setting of the operating point of the last inverter stage (i4) is effected either by directly connecting input and output (via T6) or by connecting the output of the last inverter stage (i4) to its input via the circuit component (A1; via T11 and T15) which serves to produce the internal base potential (GND) or by connecting the output of the last inverter (i4) to its input via the circuit component A2; via T16 and T20) which serves to produce the internal reference potential (REF).

6. An integrated semiconductor circuit as claimed in Claim 2, characterised in that the driver (T) in the circuit component (A1), which serves to produce the internal base potential (GND), consists of three self-blocking MOS-field-effect transistors (T12, T13, T14) and a self-conductive transistor (T$_1^*$).

7. An integrated semiconductor circuit as claimed in Claim 2, characterised in that the driver (T) in the circuit component (A2) which serves to produce the internal reference potential (REF) consists of three self-blocking MOS-field-effect transistors (T17, T18, T19) and a self-conducting MOS-field-effect transistor (T$_2^*$).

8. An integrated semiconductor circuit as claimed in one of the preceding Claims, characterised in that the sequential switching circuits (SW1, SW2) are formed by self-blocking transistor switches (T1, T2, T21, T22, T23, T24, T25, T*), whose control electrodes are each driven via a voltage doubler circuit (BS1, BS2, BS6, BS7, BS3, BS4, BS5, BS*).

9. An integrated semiconductor circuit as claimed in Claim 8, characterised in that the individual voltage doublers are constructed with their input (e) connected via a transfer transistor (t1), controlled by a first clock signal ($\Phi_1$) and followed by an inverter (i), to a node from which on the one hand the source-drain path of a transfer transistor (t2), controlled by a second clock signal ($\Phi_2$), leads to the first terminal of a first NOR-gate (n1), from which secondly a direct connection exists to the first input of a second NOR-gate (n2), whose other input is controlled by the second clock signal ($\Phi_2$), from which thirdly a direct connection leads to the second input of the first NOR-gate (n1), and from which fourthly the gate of a third MOS-field-effect transistor (t3) is controlled, whose source-drain path is bridged by a capacitor (c) to form the link between the output of the first NOR-gate (n1) and the output (a″) of the voltage doubler, and that finally the output of the second NOR-gate (n2) serves to control a further self-blocking MOS-field-effect transistor (t4) which connects the output (a″) of the voltage doubler to the supply terminal which conducts the supply potential (V$_{CC}$).

FIG 1

FIG 2

# FIG 3

# FIG 4a

# FIG 4b

FIG 4

0 135 686